# EUROPEAN PATENT APPLICATION

(11) **EP 2 829 794 A1**
(43) Date of publication of application: **28.01.2015**
(21) Application number: 12871995.2
(22) Date of filing: 21.12.2012
(51) Int. Cl.: F21V 25/04, F21S 2/00, F21V 8/00, F21V 23/00, H01S 5/062, H05B 37/02, F21Y 101/02

(54) **SOLID ILLUMINATION DEVICE**

(30) Priority: 22.03.2012 JP 2012065686
(71) Applicant: Toshiba Lighting & Technology Corporation, Yokosuka-shi, Kanagawa 237-8510 (JP)
(72) Inventor: ISHIKAWA, Masato, Imabari-shi Ehime 794-8510 (JP); HEIKE, Atsushi, Imabari-shi Ehime 794-8510 (JP)
(74) Representative: Willquist, Sofia Ellinor
(86) International application number: PCT/JP2012/083324
(87) International publication number: WO 2013/140691

(57) **Abstract**

A solid-state lighting device includes a light source section, a light emitting section, a light receiving section, a light guiding section, and a protection circuit. The light source section has a semiconductor laser including a light emitting layer made of nitride, and a driving circuit. The light source section emits laser light having a wavelength range from bluish purple to blue. The light emitting section includes a heat conduction part which includes a wavelength conversion layer absorbs the laser light and emits wavelength-converted light, and an optical part which is capable of guiding the laser light. The light receiving section is capable of detecting returning light from the optical part. The light guiding section guides the laser light from the light source section toward the optical part, and guides returning light from the optical part toward the light receiving section. The protection circuit outputs a driving stop signal toward the driving circuit if it is detected that amount of the returning light is not included in a prescribed range using an electrical signal output from the light receiving section. The driving circuit stops driving the semiconductor laser if the driving stop signal is input.

## Description

### Technical Field

The present invention relates to a solid-state lighting device.

### Background Art

A white Solid-State Lighting (SSL) device includes a semiconductor light emitting element, such as a Light Emitting Diode (LED), or a Laser Diode (LD), and a wavelength conversion layer.

It is strongly necessary for the solid-state lighting device to have high brightness and high power. Therefore, it is increasingly necessary for light emitted from a semiconductor light emitting element or wavelength-converted light generated due to a wavelength conversion layer to have high power.

Therefore, when the light which is emitted from the light emitting element or the wavelength conversion layer is not normally emitted, it is desired for the solid-state lighting device to include a self-diagnosis function capable of detecting abnormalities for the purpose of safety.

### Citation List

### Patent Literature

[PTL 1] JP-A-2007-52957

### Summary of Invention

### Technical Problem

A solid-state lighting device which has high brightness and which is enhanced in safety is provided.

### Solution to Problem

According to the exemplary embodiments, a solid-state lighting device includes a light source section, a light emitting section, a light receiving section, a light guiding section, and a protection circuit. The light source section has a semiconductor laser made of nitride material, and a driving circuit which controls the semiconductor laser. The light source section emits laser light having a wavelength range from bluish purple color to blue. The light emitting section includes a heat conduction part which includes a first surface, a wavelength conversion layer which is provided on the first surface, absorbs the laser light, and emits wavelength-converted light, and an optical part which is provided on the first surface and the wavelength conversion layer and is capable of guiding the laser light. The light receiving section is capable of detecting returning light from the optical part. The light guiding section guides the laser light from the light source section toward the optical part and guides the returning light from the optical part toward the light receiving section. The protection circuit outputs a driving stop signal toward the driving circuit if it is detected that amount of the returning light is not included in a prescribed range using an electrical signal output from the light receiving section. The driving circuit stops driving the semiconductor laser if the driving stop signal is input.

### Brief Description of Drawings

[Fig. 1] Fig. 1 is a configuration diagram illustrating a solid-state lighting device according to a first embodiment.
[Fig. 2] Fig. 2(a) is a perspective view schematically illustrating the solid-state lighting device, and Fig. 2(b) is a cross-sectional diagram schematically illustrating the vicinity of a light emitting section taken along a line B-B.
[Fig. 3] Fig. 3 is a configuration diagram illustrating a solid-state lighting device according to a second embodiment.
[Fig. 4] Fig. 4 is a configuration diagram illustrating a solid-state lighting device according to a third embodiment.
[Fig. 5] Fig. 5 is a configuration diagram illustrating a solid-state lighting device according to a fourth embodiment.
[Fig. 6] Fig. 6 is a timing chart illustrating a self-diagnosis system.
[Fig. 7] Fig. 7 is a configuration diagram illustrating a solid-state lighting device according to a fifth embodiment.
[Fig. 8] Fig. 8 is a graph illustrating an action of a calculation circuit according to the fifth embodiment.
[Fig. 9] Fig. 9 is a schematic diagram illustrating a configuration of a projector which is an example of an application example of the solid-state lighting device.
[Fig. 10] Fig. 10 is a block diagram illustrating functions of the projector.

### Description of Embodiments

Hereinafter, exemplary embodiments will be described with reference to the accompanying drawings.

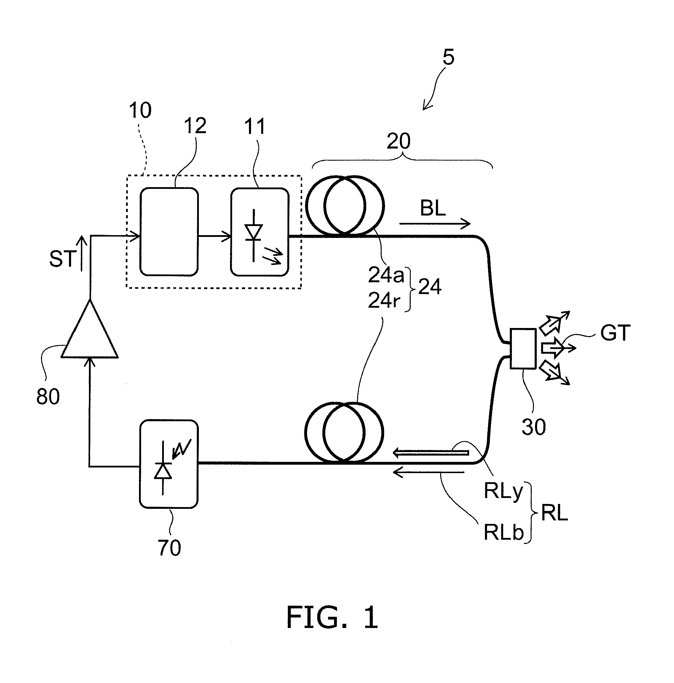

Fig. 1 is a configuration diagram illustrating a solid-state lighting device according to a first embodiment.

A solid-state lighting device 5 includes a light source section 10, a light guiding section 20, a light emitting section 30, a light receiving section 70, and a protection circuit 80.

The light source section 10 includes a semiconductor laser 11 which has a light emitting layer configured from nitride, and a driving circuit 12 which controls the semiconductor laser 11. In addition, the light source section 10 emits laser light which have a wavelength range from bluish purple to blue. It is possible for the driving circuit 12 to perform on and off switching, current control, pulse lighting control, and the like on the of the semiconductor laser 11.

Meanwhile, in the specification, it is assumed that the wavelength of bluish purple light ranges 380 nm or greater to 430 nm or less. In addition, the wavelength of blue light ranges 430 nm or greater to 480 nm or less.

The light emitting section 30 includes a heat conduction part, a wavelength conversion layer which is provided on the surface of the heat conduction part, absorbs the laser light, and emits wavelength-converted light, and an optical part which is provided on the surface of the heat conduction part and the wavelength conversion layer. In addition, in the light emitting section 30, the laser light, which are incident on the optical part from the light guiding section 20, are guided in the optical part and then the wavelength conversion layer is irradiated with the laser light.

The light receiving section 70 is configured from, for example, silicon photodiode or the like, and is capable of detecting returning light RL which includes returning light RLb of laser light and returning light RLy of wavelength-converted light.

The light guiding section 20 guides the laser light from the light source section 10 toward the light emitting section 30, and guides the returning light RL from the light emitting section 30 toward the light receiving section 70. Meanwhile, the light guiding section 20 can include a plurality of optical fibers 24 which are capable of guiding the respective laser light. The optical fibers, through which the returning light RL is guided, may be dedicated to the returning light or fibers for transmission of laser light may be shared.

If a wavelength conversion layer 32 is damaged due to excessive vibration, shocks, or the like, there is a case in which the laser light leak to the outside. If the wavelength conversion layer 32 made of a phosphor or the like is excited using laser light which has a higher optical density than an LED, a heat generation amount increases. In this case, if the thermal expansion and contraction of a heat conduction part 34 are repeated in accordance with the laser light being on and off, there are cases in which cracks or desquamation occurs in the wavelength conversion layer 32, and in which the wavelength conversion layer 32 is not irradiated with the laser light and the laser light are emitted to the outside without change. It is desirable that the intensity of such leaking light be low for the purpose of safety of human eyes.

If the protection circuit 80 detects that the amount of the returning light RL is at an abnormal value which is not included in a predetermined range using an output electrical signal from the light receiving section 70, the protection circuit 80 outputs a driving stop signal ST toward the driving circuit 12. The driving circuit 12 changes the semiconductor laser 11 into an off state using the driving stop signal ST. By doing so, when a state is deviated from a normal operation state, the laser light is immediately turned off, and thus it is possible to ensure the safety of the solid-state lighting device.

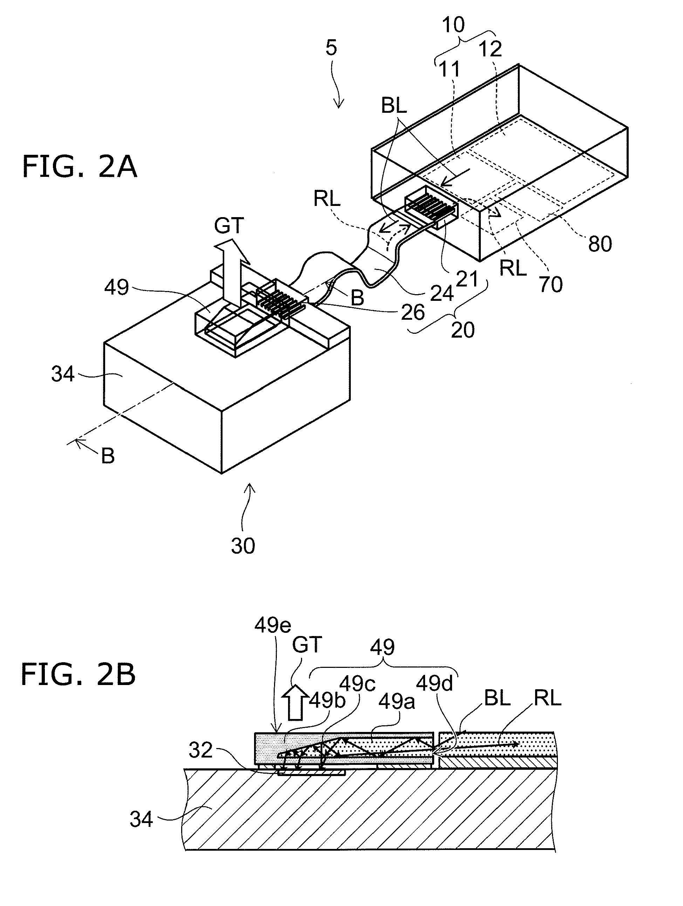

Fig. 2(a) is a perspective view schematically illustrating the solid-state lighting device, and Fig. 2(b) is a cross-sectional diagram schematically illustrating the vicinity of the light emitting section taken along a line B-B.

Although it is assumed that the light guiding section 20 includes the optical fibers 24, a light guiding path which is configured from transparent resin, glass or the like may be included. In addition, laser light are blue light.

As shown in Fig. 2(a), the light guiding section 20 of the solid-state lighting device 5 includes a connector 21 which is optically coupled and connected to the light source section 10, the optical fibers 24, and a connector 26 which is optically coupled and connected to the light emitting section 30. For example, multi-core optical fibers can be used as the optical fibers 24. In this case, the multi-core optical fibers include optical fibers 24a which propagate the blue laser light BL from the semiconductor laser 11 toward the light emitting section 30, and optical fibers 24r which propagate the returning light RL from the light emitting section 30 toward the light receiving section 70. Meanwhile, the returning light RL may be propagated in the optical fibers 24a which propagate the blue light BL, and then may be incident on the light receiving section 70.

In addition, as shown in Fig. 2(b), the light emitting section 30 includes the heat conduction part 34, the wavelength conversion layer 32 which is provided on the surface of the heat conduction part 34, absorbs the blue laser light BL, and emits the wavelength-converted light, and the optical part 49. The light emitting section 30 emits mixed light GT acquired by mixing the blue laser light BL and the wavelength-converted light.

The blue laser light BL are introduced from one end portion of the optical fibers 24 to the side surface 49d of the optical part 49. The wavelength conversion layer 32 which includes yellow phosphor particles or the like emits yellow wavelength-converted light. Therefore, for example, white light is emitted from the upper surface 49e of the optical part 49 as the mixed light GT which is acquired by being mixed with the blue laser light BL. Meanwhile, even when the wavelength conversion layer 32 includes phosphor, such as a red color (R), a green color (G), and a blue color (B), it is possible to emit white light.

In addition, the optical part 49 includes a structure in which a core portion 49a having a high refractive index is sandwiched by a cladding portion 49b, configured from glass having a low refractive index, from the upper and the lower sides. Therefore, the laser light with high directivity is propagated to the core portion 49a.

In the embodiment, a taper portion 49c is provided on the end portion of the core portion 49a. When the taper portion 49c is provided, the laser light are effectively irradiated on the upper surface of the wavelength conversion layer 32 while not being totally reflected in an interface having vertically different refractive indexes. It is possible to control the brightness of a micro light emitting surface by controlling the distribution of irradiation depending on the shape of the taper portion 49c. Since difference in the refractive indexes between the cladding portion 49b and the core portion 49a is relatively small, distribution of white light emitted in the wavelength conversion layer 32 is hardly affected.

Some of the white light can become the returning light RL, can be propagated in the optical fibers 24, and can be incident on the light receiving section 70.

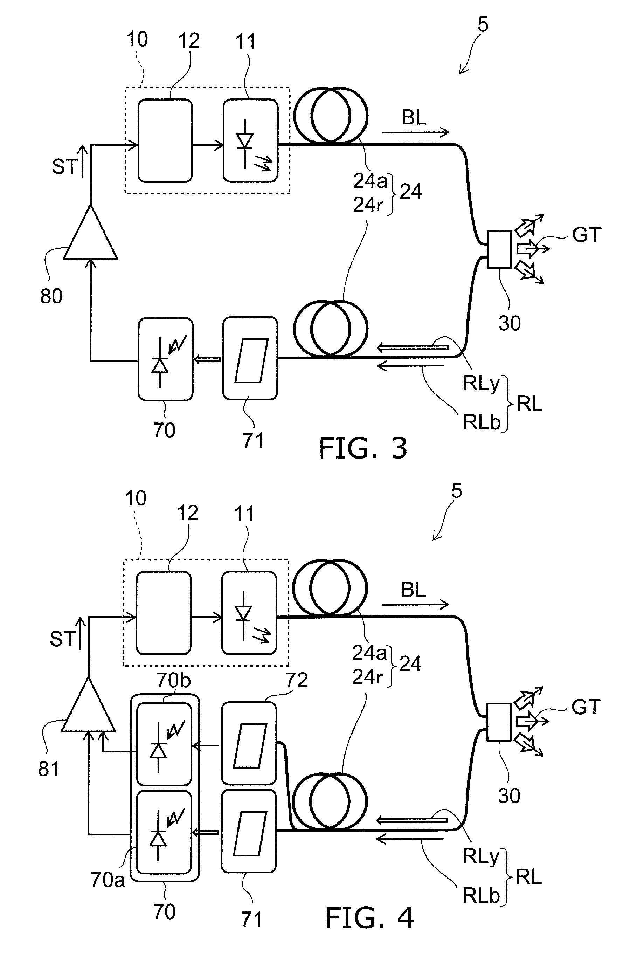

Fig. 3 is a configuration diagram illustrating a solid-state lighting device according to a second embodiment.

The solid-state lighting device 5 according to the second embodiment further includes a blue light cut-off filter 71 which is provided in front of the light receiving section 70. If the wavelength conversion layer 32 is damaged, the yellow light decreases and the blue light BL increases. Therefore, there is a case in which it is possible to detect the amount of the white light but it is not possible to precisely detect the abnormality of the wavelength conversion layer 32.

In contrast, in the second embodiment, the yellow light RLy is selectively transmitted and incident on the light receiving section 70 from among the returning light RL which is emitted from the optical fibers 24r. Therefore, it is possible for the light receiving section 70 to detect the decrease in the amount of the yellow light due to not only the damage of the optical fiber 24 but also the damage of the wavelength conversion layer 32. In this way, it is possible to perform self-diagnosis on the abnormality of white light and to ensure the safety of the solid-state lighting device.

Fig. 4 is a configuration diagram illustrating a solid-state lighting device according to a third embodiment.

The solid-state lighting device 5 according to the third embodiment includes a first light receiving section 70a which detects light that passes through a blue light cut-off filter 71, and a second light receiving section 70b which detects light that passes through a yellow light cut-off filter 72. The first light receiving section 70a and the second light receiving section 70b are provided in parallel between optical fibers 24r for returning light and a protection circuit 81.

In this case, the protection circuit 81 includes a comparison circuit which compares an output electrical signal of the first light receiving section 70a with an output electrical signal of the second light receiving section 70b. When the comparison between the output electrical signal of the first light receiving section 70a with the output electrical signal of the second light receiving section 70b is not included in a prescribed range, the protection circuit 81 outputs a driving stop signal ST toward a driving circuit 12, and stops driving a semiconductor laser 11. In this way, it is possible to perform self-diagnosis on the abnormality of white light and to ensure the safety of the solid-state lighting device.

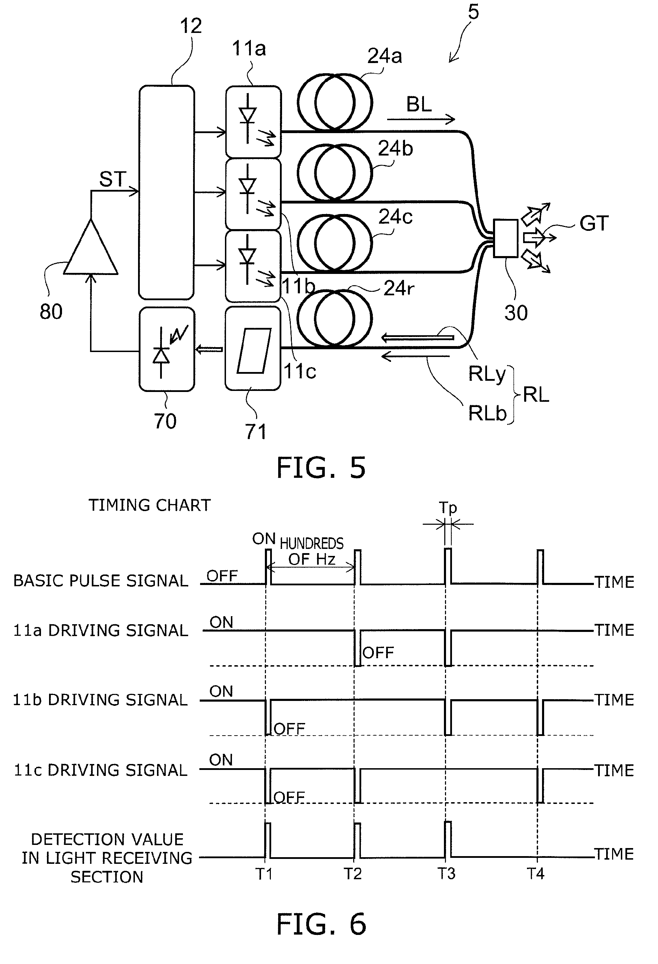

Fig. 5 is a configuration diagram illustrating a solid-state lighting device according to a fourth embodiment.

The solid-state lighting device according to the fourth embodiment includes a plurality of semiconductor laser elements (laser elements) 11. When the plurality of semiconductor laser elements 11 and the plurality of optical fibers 24 are included and an abnormality occurs in any one of them, the amount of change in the returning light RL is small relative to the whole, and thus abnormality determination accuracy is low. In addition, in a case of the solid-state lighting device which includes the plurality of semiconductor laser elements 11, it is necessary to specify an abnormality occurrence spot. The fourth embodiment corresponds to the solid-state lighting device which includes a self-diagnosis system that specifies a semiconductor laser element 11 in which an abnormality occurs.

In Fig. 5, the solid-state lighting device 5 includes three semiconductor laser elements 11a, 11b, and 11c, and three optical fibers 24a, 24b, and 24c which respectively guide the blue laser light BL. In addition, an optical fiber 24r which guides the returning light RL may be further included. After the blue laser light BL from the semiconductor laser elements 11 are respectively incident on and guided to one end surfaces of the opposite optical fibers 24, the blue laser light BL are emitted from the other end surfaces of the optical fibers 24 and are irradiated to the wavelength conversion layer 32.

The returning light RL from the light emitting section 30 is guided to the optical fiber 24r and is incident on the blue light color cut-off filter 71. The returning light RL, from which the light emitting spectrum in the vicinity of the blue light BL is cut, is incident on the light receiving section 70.

Fig. 6 is a timing chart illustrating a self-diagnosis system.

The driving circuit 12 generates a basic pulse signal which has a pulse width Tp on a repetition frequency f. For example, it is possible to set the repetition frequency f to hundreds of Hz that are hardly sensed by human eyes. Only the first semiconductor laser element 11a is switched on between time T1 and time (T1+Tp). If the light receiving section 70 detects that the amount of the light of the first semiconductor laser element 11a is included in a prescribed range, the light receiving section 70 determines that an operation is normal. On the other hand, as shown between time T4 and time (T4+Tp), if the light receiving section 70 detects that the amount of the light of the first semiconductor laser element 11a is not included in the prescribed range, the light receiving section 70 determines an abnormality, such as the damage of the optical fiber 24a, the damage of the wavelength conversion layer 32, or the deterioration of the semiconductor laser element 11a.

In the same manner, only the second semiconductor laser element 11b is switched on between time T2 and time (T2+Tp) and only the third semiconductor laser element 11c is switched on between time T3 and time (T3+Tp). After one cycle of the basic pulse signal is generated, the sequence is repeated. As a result, it is possible to perform self-diagnosis in order to determine whether or not the operation of the solid-state lighting device 5 is normal. That is, when a plurality of independent light paths, which each include the semiconductor laser element 11, the optical fibers 24, and the wavelength conversion layer 32, are provided, it is possible to specify a light path in which an abnormality occurs. Therefore, it is possible to increase the safety of the solid-state lighting device by, for example, stopping driving of the semiconductor laser element 11 of the light path in which an abnormality occurs. Meanwhile, a driving method for determining the abnormality of the light path is not limited to the example shown in Fig. 6.

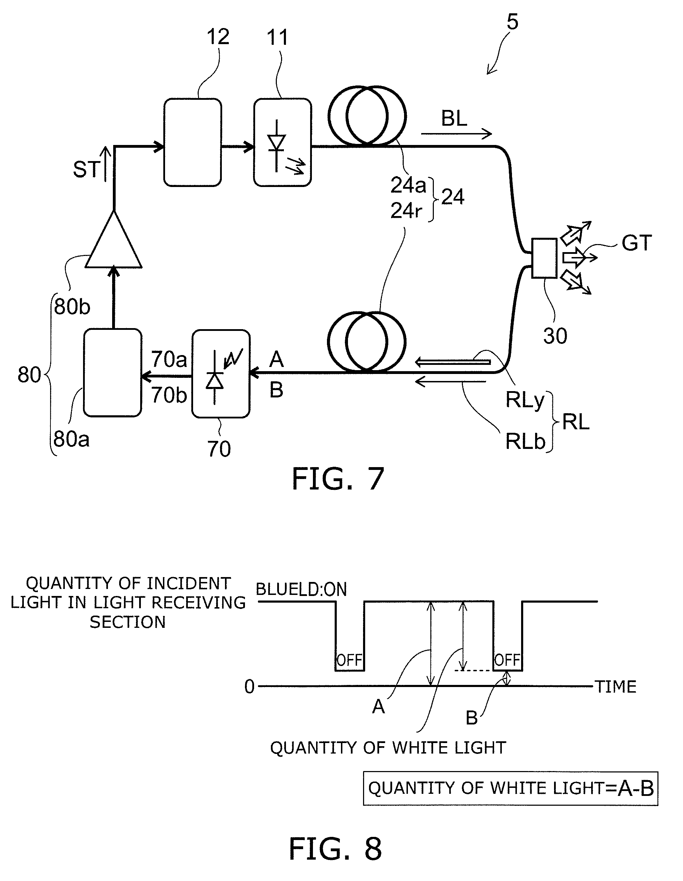

Fig. 7 is a configuration diagram illustrating a solid-state lighting device according to a fifth embodiment.

A protection circuit 80 according to the fifth embodiment includes a calculation circuit 80a which calculates the output of a light receiving section 70, and an output control circuit 80b of the semiconductor laser 11. For example, even when it is desired to perform control such that the blue light BL has a prescribed value by feeding back the amount of the returning light RL, it is difficult to perform accurate control if a large amount of ambient light is included in the returning light RL.

Fig. 8 is a graph illustrating an action of a calculation circuit according to the fifth embodiment.

The ambient light corresponds to the amount B of light which is incident on the light receiving section 70 when the semiconductor laser 11 is turned off. When it is assumed that the amount of light, which is incident on the light receiving section 70 when the semiconductor laser 11 is turned on, is A, the amount of white light is a value (A-B) acquired by subtracting the quantity B of incident light from the amount A of incident light. It is possible to more accurately control the amount of the blue light BL by inputting a value, acquired by subtracting the output electrical signal 70b of the light receiving section 70 which corresponds to the amount B of incident light from the output electrical signal 70a of the light receiving section 70 which corresponds to the amount A of incident light, to the output control circuit 80b. Meanwhile, even though the blue light cut-off filter is interposed between the light receiving section 70 and the optical fibers 24r in Fig. 7, it is possible to accurately control the amount of the blue light BL by reducing the influence of the ambient light.

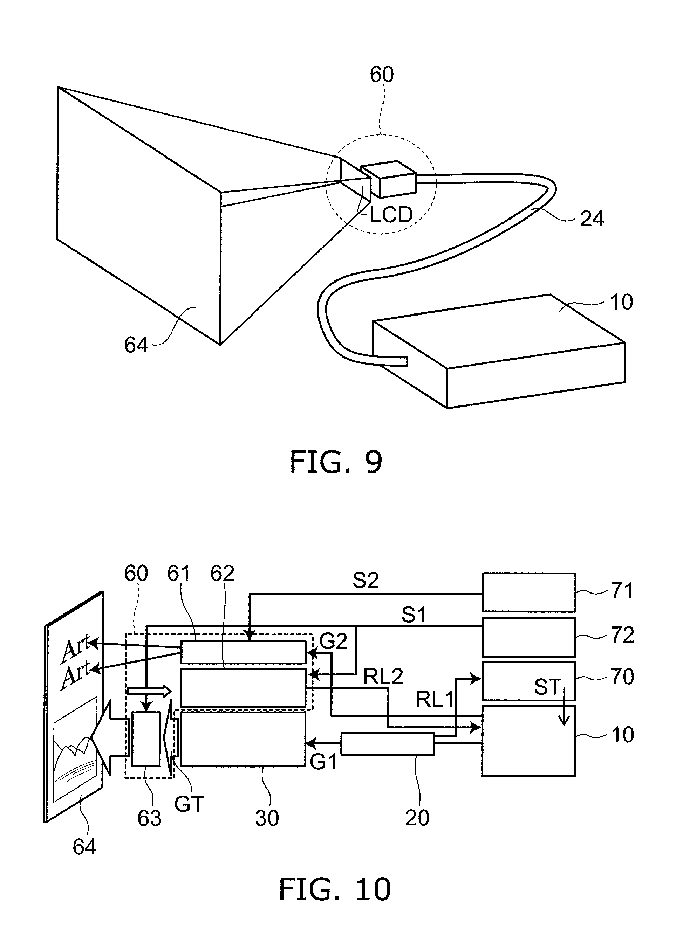

Fig. 9 is a schematic diagram illustrating a configuration of a projector which is an example of an application example of the solid-state lighting device.

A semiconductor laser which generates a large amount of heat and a driving circuit are stored in a light source section 10. Regardless that the light emitting section which is connected to the light source section 10 by an optical fiber 24 can generate a large quantity (amount) of light and can emit light with high brightness, the light emitting section can be small and lightweight while generating low heat.

In a projection unit 60 which projects an image on a screen 64, a shutter which is configured from a liquid crystal device or the like is provided in front of the light emitting section. Since the power consumption of the liquid crystal device is low, the liquid crystal device generates little heat. In addition, when power is supplied in a wireless manner using microwaves, a connector which transmits an optical signal may be provided in the optical fiber 24. It is apparent that it is possible to provide a connector which transmits an electrical signal. If an optical fiber bundle passes through a free pipe such that the light emitting section can freely adjust an angle of a neck, it is possible to adjust an irradiation position by one touch.

Fig. 10 is a block diagram illustrating functions of the projector.

The projector includes the projection unit 60, the solid-state lighting device, a sweeping signal driving unit 71, and an image signal driving unit 72. The projection unit 60 includes an image unit 63, a sweeping optical part 61, and an external signal sensor section 62. In addition, the image unit 63 may include a liquid crystal shutter.

The solid-state lighting device includes the light source section 10, the light guiding section 20, and the light emitting section 30. Laser light G1 which are emitted from the light source section 10 are propagated to the light guiding section 20 and are incident on the light emitting section 30. White light GT which is emitted from the light emitting section 30 acts as a backlight for the image unit 63. In addition, the light source section 10 can propagate the blue laser light BL to the sweeping optical part 61.

The returning light RL from the optical part passes through the light guiding section 20 and is incident on the light receiving section 70. The returning light RL includes the blue laser light and the wavelength-converted light which are reflected in the optical part. It is possible to detect an abnormality of the white light by the self-diagnosis system.

An image signal S1 from the image signal driving unit 72 is input to the image unit 63, and an image is projected toward the screen 64. In addition, a sweeping signal S2 from the sweeping signal driving unit 71 is input to the sweeping optical part 61.

In addition, when a signal transmission system is used for only light, it is possible to generate light on a light emitting head side using some of the output of the high power laser and to transmit power for a control signal through the optical fibers or the like.

The solid-state lighting device according to the embodiment is small and lightweight, generates little heat, and is capable of easily improving safety. Such a solid-state lighting device is not limitedly applied to a projector. The solid-state lighting device can be widely applied to stage lighting, a street light, a searchlight, a headlight, underwater lighting, and the like. For example, in a case of the stage lighting, the solid-state lighting device can be used for projection or spotlighting. In this case, the color or the brightness of the local part of a micro light emitting section can be dimmed. Therefore, although resolution is low, a great effect can be acquired for calculation.

In addition, if the external signal light sensor section 62 detects an external light signal, such as infrared rays, a signal RL2, such as infrared rays or electricity, is transmitted toward the light source section 10, and thus it is possible to perform control such that the semiconductor laser is switched on or off. Such a solid-state lighting device can be used as lighting for explosion-proof, security lighting capable of recording images, or the like.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A solid-state lighting device comprising:
a light source section that has a semiconductor laser including a light emitting layer made of nitride, and a driving circuit which controls the semiconductor laser, the light source section emitting a laser light having a wavelength range from bluish purple to blue;
a light emitting section that includes a heat conduction part which includes a first surface, a wavelength conversion layer which is provided on the first surface, absorbs the laser light, and emits wavelength-converted light, and an optical part which is provided on the first surface and the wavelength conversion layer and is capable of guiding the laser light;
a light guiding section that guides the laser light from the light source section toward the optical part, and guides returning light from the optical part;
a light receiving section that is capable of detecting the returning light which is guided in the light guiding section; and
a protection circuit that outputs a driving stop signal toward the driving circuit if it is detected that amount of the returning light is not included in a prescribed range using an electrical signal output from the light receiving section,
the driving circuit stopping driving the semiconductor laser if the driving stop signal is input.

2. The device according to Claim 1,
wherein
the semiconductor laser includes a plurality of laser elements, and
wherein the light guiding section includes a plurality of light paths, and each light path guides at least one laser light from the plurality of laser elements.

3. The device according to Claim 2,
wherein the protection circuit specifies a light path, in which an abnormality of amount of the returning light occurs in the plurality of light paths, and outputs the driving stop signal to stop driving a laser element which introduces a laser light to the light path in which the abnormality occurs.

4. The device according to Claim 3,
wherein the driving circuit drives the plurality of laser elements under pulse signal sequentially so as to turn on only one laser element of the plurality of laser elements and to turn off remaining laser elements, and
wherein, when the amount of the returning light does not reach the prescribed range even though a turned-on pulse signal is added, the protection circuit specifies the abnormality in the light path.

5. The device according to Claim 2,
wherein the returning light is guided in at least one of the plurality of light paths or guided in a returning light-dedicated light path which is included in the light guiding section.

6. The device according to Claim 2,
wherein the light paths include optical fibers.

7. The device according to Claim 1,
wherein the returning light includes the laser light and the wavelength-converted light.

8. The device according to Claim 2,
wherein the driving circuit performs on and off switching, current control, and pulse lighting control on the plurality of laser elements.

9. The device according to Claim 1, further comprising:
a blue light cut-off filter provided between the light guiding section and the light receiving section,
wherein the light receiving section detects amount of the wavelength-converted light which passes through the blue light cut-off filter in the returning light.

10. The device according to Claim 1 further comprising:
a blue light cut-off filter provided between the light guiding section and the light receiving section; and
a yellow light cut-off filter provided between the light guiding section and the light receiving section,
wherein the protection circuit includes a comparison circuit that compares amount of the wavelength-converted light which passes through the blue light cut-off filter with amount of the laser light which pass through the yellow light cut-off filter.

11. The device according to Claim 1,
wherein the protection circuit further includes a calculation circuit that calculates amount of light in the light receiving section.

12. The device according to Claim 1,
wherein the calculation circuit subtracts an electrical output signal of the light receiving section that corresponds to amount of incident light when the semiconductor laser is turned off from an electrical output signal of the light receiving section that corresponds to amount of incident light when the semiconductor laser is turned on.
